# EUROPEAN PATENT APPLICATION

(11) **EP 2 768 285 A1**
(43) Date of publication of application: **20.08.2014**
(21) Application number: 12840616.2
(22) Date of filing: 24.08.2012
(51) Int. Cl.: H05B 33/10, H01L 51/50

(54) **METHOD FOR MANUFACTURING ORGANIC ELECTROLUMINESCENT ELEMENT**

(30) Priority: 12.10.2011 JP 2011224518
(71) Applicant: Nitto Denko Corporation, Ibaraki-shi, Osaka 567-8680 (JP)
(72) Inventor: KAKIUCHI, Ryohei, Osaka 567-8680 (JP); HIDA, Kanako, Osaka 567-8680 (JP); MORITA, Shigenori, Osaka 567-8680 (JP)
(74) Representative: Grünecker, Kinkeldey, Stockmair & Schwanhäusser
(86) International application number: PCT/JP2012/071405
(87) International publication number: WO 2013/054599

(57) **Abstract**

A method for producing an organic EL element having excellent electric properties in a relatively low cost is provided. The present invention is a method of producing the organic EL element including at least two organic layers of a first organic layer and a second organic layer, and a mixed layer in which forming materials of both of the layers are mixed between the first organic layer and the second organic layer. The method including the steps of using a vapor deposition apparatus 7 including a first vapor deposition source 721 including the first organic layer forming material and a second vapor deposition source 722 including the second organic layer forming material; forming the first organic layer on a surface to be processed of a substrate 73 by colliding the first organic layer forming material vaporized from the first vapor deposition source 721 with the surface to be processed of the substrate 73; and thereafter, forming the mixed layer by colliding the vaporized second organic layer forming material from the second vapor deposition source 722 with the first organic layer in a migration state of the first organic layer forming material.

## Description

### TECHNICAL FIELD

The present invention relates to a method for producing an organic electroluminescence element.

### BACKGROUND ART

The organic electroluminescence element has a positive electrode, a negative electrode, and an organic electroluminescence layer including a light emitting layer provided between the positive electrode and the negative electrode. Hereinafter, organic electroluminescence is described as "organic EL".

In the organic EL element, excitons are generated by recombining electrons and holes that are injected from the electrode to the light emitting layer. When the excitons return to a ground state, light is emitted.

The organic EL layer includes, for example, a hole injection layer and a hole transport layer which are provided at the positive electrode side, an electron injection layer and an electron transport layer which are provided at the negative electrode side, and a light emitting layer provided between the hole transport layer and the electron transport layer. The hole transport layer has a function of injecting holes to the light emitting layer and the electron transport layer has a function of injecting electrons to the light emitting layer.

Patent Document 1 discloses an organic EL element containing a mixed layer in which the forming materials of both of the hole transport layer and the light emitting layer or materials of both of the light emitting layer and the electron transport layer are mixed in at least one position between the hole transport layer and the light emitting layer or between the light emitting layer and the electron transport layer in order to smoothly transfer holes and electrons to the light emitting layer.

For example, such an organic EL element can be produced by depositing the hole transport layer onto the surface of the electrode in a substrate having the electrodes using a first vapor deposition apparatus, subsequently co-depositing the mixed layer onto the surface of the hole transport layer using a second vapor deposition apparatus, and further depositing the light emitting layer onto the surface of the mixed layer using a third vapor deposition apparatus.

In the production method described above, however, independent three vapor deposition apparatuses are required (that is, independent three vapor deposition chambers) in order to form the organic EL layer having the mixed layer.

Therefore, a cost of the facilities for producing the organic EL layer increases and, as a result, a cost of the organic EL element cannot be reduced.

The substrate is required to be transferred between the independent three vapor deposition chambers, and thus, relatively long time is required for a vapor deposition process. Particularly, the production efficiency is low when the organic EL layer is formed on the substrate by a roll-to-roll method.

### [Patent Document]

[Patent Document 1]
Japanese Unexamined Patent Publication No. 3-190088

The purpose of the present invention is to provide a method for producing an organic EL element having excellent electric properties in a relatively low cost.

In consideration of the problem, the inventors of the present invention noticed that the mixed layer in which forming materials of two organic layers are mixed is formed between the two organic layers in one vapor deposition apparatus.

Specifically, the method includes the steps of parallelly providing two vapor deposition sources storing each of the forming materials of two organic layers in a chamber of one vapor deposition apparatus, depositing a forming material of one organic layer on a substrate to form a vapor-deposited film, and, thereafter, depositing a forming material of the other organic layer on the vapor-deposited film.

When the forming materials of the two organic layers are merely deposited in sequence, however, the mixed layer hardly formed between the two organic layers. Even when the mixed layer is formed, only an organic EL element having poor electric properties is obtained.

The inventors of the present invention further repeated trial and error and carried out insensitive studies, and, as a result, created the present invention.

In the present invention, in a method for producing an organic EL element including at least two organic layers of a first organic layer and a second organic layer, and a mixed layer in which forming materials of both of the layers are mixed between the first organic layer and the second organic layer, the method includes the steps of: using a vapor deposition apparatus including a first vapor deposition source including the first organic layer forming material and a second vapor deposition source including the second organic layer forming material; forming the first organic layer on a surface to be processed of a substrate by colliding the first organic layer forming material vaporized from the first vapor deposition source with the surface to be processed of the substrate; and thereafter, forming the mixed layer by colliding the second organic layer forming material vaporized from the second vapor deposition source with the first organic layer in a migration state of the first organic layer forming material.

In a preferable production method of the present invention, the second vapor deposition source has a discharge opening that acts as an outlet of the vaporized second organic layer forming material, and a distance between the discharge opening of the second vapor deposition source and the surface to be processed of the substrate is set to 0.1 mm to 5.0 mm.

In a preferable production method of the present invention, the first vapor deposition source has a discharge opening that acts as an outlet of the vaporized first organic layer forming material, and a distance between the discharge opening of the first vapor deposition source and the surface to be processed of the substrate is set to 0.1 mm to 5.0 mm.

In a preferable production method of the present invention, the vaporized second organic layer forming material is collided with the first organic layer during a period of 0.3 seconds to 3.0 seconds after forming the first organic layer.

In a preferable production method of the present invention, vapor deposition rate of the forming materials of the second organic layer is 40 nm/second to 500 nm/second.

In a preferable production method of the present invention, the first organic layer forming material and the second organic layer forming material are sequentially collided, relatively moving the first vapor deposition source and the second vapor deposition source and the substrate.

In a preferable production method of the present invention, the first vapor deposition source and the second vapor deposition source are parallelly arranged in one chamber of the vapor deposition apparatus, and the first organic layer forming material and the second organic layer forming material are sequentially collided in the chamber, moving a sheet-like substrate by a roll-to-roll method.

According to the production method of the present invention, an organic EL element can be produced in a relatively low cost because the organic EL layer having the mixed layer between two organic layers can be formed in one chamber of a vapor deposition apparatus. According to the production method of the present invention, an organic EL element having excellent electric properties can be obtained because the adequate mixed layer is formed between the two organic layers.

### BRIEF DESCRIPTION OF THE DRAWINGS

Fig. 1 illustrates a schematic sectional view of an organic EL element according to one embodiment of the present invention.
Fig. 2 illustrates a schematic sectional view of an organic EL element according to other embodiment of the present invention.
Fig. 3 illustrates a schematic sectional view of an organic EL element according to other embodiment of the present invention.
Fig. 4 illustrates a schematic sectional view of an organic EL element according to other embodiment of the present invention.
Fig. 5 illustrates a conceptual diagram of a vapor deposition apparatus for forming an organic EL layer used in the production method of the present invention.
Fig. 6 illustrates a schematic sectional view of a vapor deposition apparatus according to one embodiment of the present invention.
Fig. 7 illustrates a schematic sectional view of a vapor deposition apparatus according to other embodiment of the present invention.
Fig. 8 illustrates a graph chart of measurement results of etching depths and concentrations of Alq₃ in organic EL elements of Examples 1 to 4 and Comparative Example 1.

### DESCRIPTION OF EMBODIMENTS

### [Organic EL element obtained from the production method of the present invention]

The organic EL element obtained from the production method of the present invention has an organic EL layer between two electrodes.

The organic EL layer has at least the two organic layers of a first organic layer and a second organic layer and the mixed layer that is sandwiched between the two organic layers. The forming materials of both of the layers are mixed in the mixed layer.

Specifically, the organic EL element of the present invention has a first electrode, a second electrode, and an organic EL layer provided between the first electrode and the second electrode, and the organic EL layer has at least one layered structure of the first organic layer, the mixed layer, and the second organic layer.

In this specification, as prefixes of the terms "first", "second", and the like may be added. These prefixes, however, are only added in order to distinguish the terms and do not have specific meaning such as order and relative merits.

The organic EL layer may be provided between the first electrode and the second electrode or two or more organic EL layers may be provided between them. When the two or more organic EL layers are provided, separation layers are preferably provided between each of the organic EL layers.

At least two of the organic layers may exist, and for example, three or more of the organic layers may exist.

When the three or more organic layers are provided, each mixed layer is provided between all organic layers, or one mixed layer is provided between only adjacent two organic layers selected from the three or more organic layers.

Examples of the organic EL layer include (A) a structure made of three organic layers of the hole transport layer, the light emitting layer, and the electron transport layer (hereinafter, this structure is referred to as an "A type organic EL layer"), (B) a structure made of two organic layers of the hole transport layer and the light emitting layer (hereinafter, this structure is referred to as a "B type organic EL layer"), and (C) a structure made of two organic layers of the light emitting layer and the electron transport layer (hereinafter, this structure is referred to as a "C type organic EL layer").

In the B type organic EL layer, the light emitting layer also acts as the electron transport layer. In the C type organic EL layer, the light emitting layer also acts as the hole transport layer.

The preferable organic EL layer of the present invention has the mixed layer in which the forming materials of both of the hole transport layer and the light emitting layer are mixed in or materials of both of the light emitting layer and the electron transport layer are mixed in at least one position between the hole transport layer and the light emitting layer or between the light emitting layer and the electron transport layer.

The A type organic EL layer, for example, has a mixed layer in which the forming materials of the hole transport layer and the light emitting layer are mixed in between the hole transport layer and the light emitting layer (hereinafter, the mixed layer in which the forming materials of the hole transport layer and the light emitting layer are mixed in is referred to as a "hole transport mixed layer"), or has a mixed layer in which the forming materials of the light emitting layer and the electron transport layer are mixed in between the light emitting layer and the electron transport layer (hereinafter, the mixed layer in which the forming materials of the light emitting layer and electron transport layer is referred to as an "electron transport mixed layer"). Alternatively, the A type organic EL layer has the hole transport mixed layer between the hole transport layer and the light emitting layer, and also has the electron transport mixed layer between the light emitting layer and the electron transport layer.

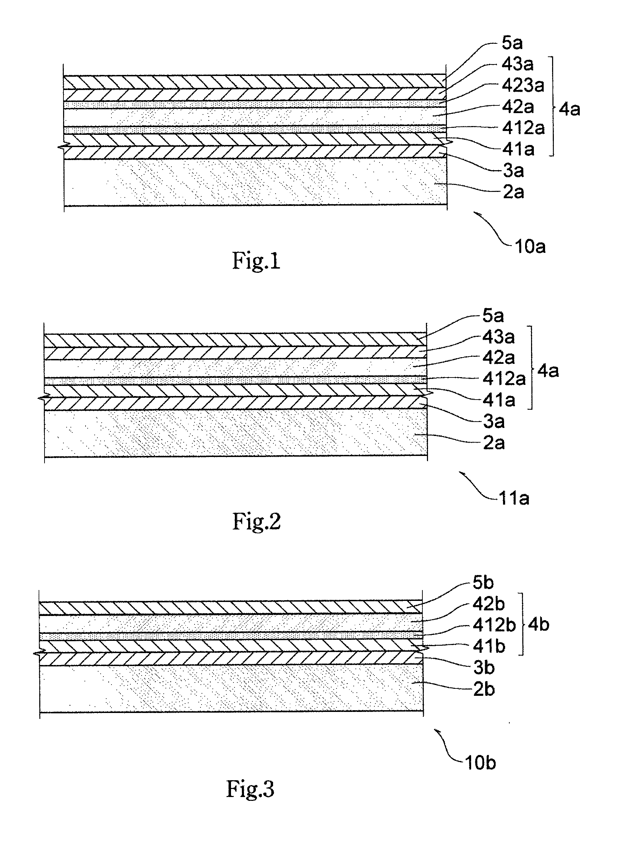

Fig. 1 illustrates a reference view of a configuration example of an organic EL element 10a having an A type organic EL layer 4a of the present invention.

In Fig. 1, the organic EL element 10a has a substrate 2a, a first electrode 3a stacked on the substrate 2a, a hole transport layer 41a stacked on the first electrode 3a, a light emitting layer 42a stacked on the hole transport layer 41a, an electron transport layer 43a stacked on the light emitting layer 42a, and a second electrode 5a stacked on the electron transport layer 43a, in sequence from the bottom. A hole transport mixed layer 412a is provided between the hole transport layer 41a and the light emitting layer 42a, and an electron transport mixed layer 423a is provided between the light emitting layer 42a and the electron transport layer 43a.

Fig. 2 illustrates a reference view illustrating other configuration examples of an organic EL element 11a having the A type organic EL layer 4a of the present invention.

The organic EL element 11a of Fig. 2 is the same as the organic EL element 10a of Fig. 1 except that the electron transport mixed layer is not present between the light emitting layer 42a and the electron transport layer 43a.

Fig. 3 illustrates a reference view illustrating one configuration example of an organic EL element 10b having the B type organic EL layer 4b of the present invention.

In Fig. 3, the organic EL element 10b has a substrate 2b, a first electrode 3b stacked on the substrate 2b, a hole transport layer 41b stacked on the first electrode 3b, a light emitting layer 42b stacked on the hole transport layer 41b, and a second electrode 5b stacked on the light emitting layer 42b. A hole transport mixed layer 412b is provided between the hole transport layer 41b and the light emitting layer 42b.

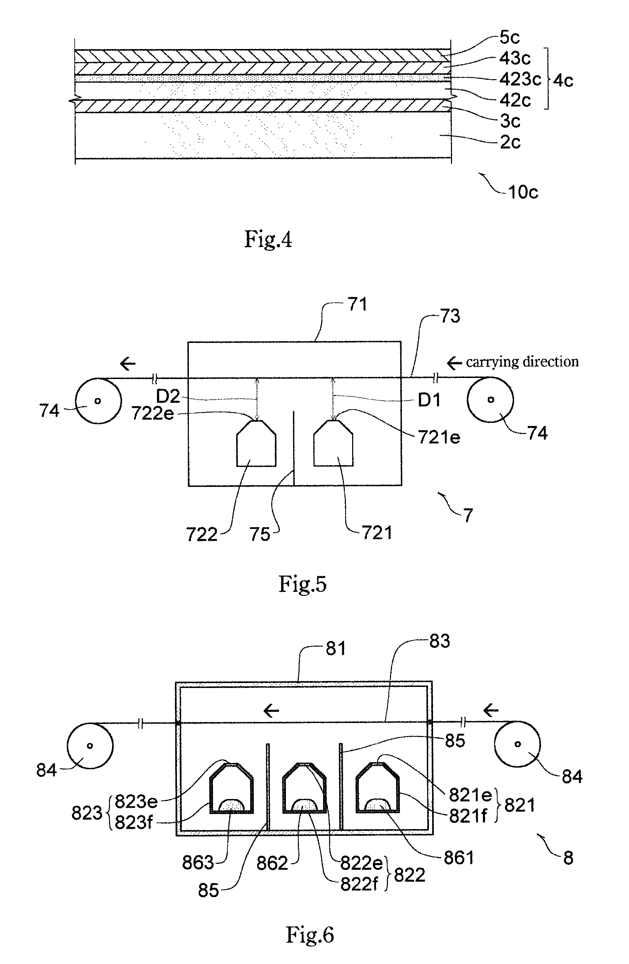

Fig. 4 illustrates a reference view illustrating one configuration example of an organic EL element 10c having the C type organic EL layer 4c of the present invention.

In Fig. 4, the organic EL element 10c has a substrate 2c, a first electrode 3c stacked on the substrate 2c, a light emitting layer 42c stacked on the first electrode 3c, an electron transport layer 43c stacked on the light emitting layer 42c, and a second electrode 5c stacked on the electron transport layer 43c. An electron transport mixed layer 423c is provided between the light emitting layer 42c and the electron transport layer 43c.

In each of the organic EL elements 10a, 11a, 10b, and 10c in Figs. 1 to 4, the first electrodes 3a, 3b, and 3c are provided on the substrates 2a, 2b, and 2c. Alternatively, the second electrodes 5a, 5b, and 5c may be provided on the substrates 2a, 2b, and 2c, or each of the first electrodes 3a, 3b, and 3c and the second electrodes 5a, 5b, and 5c may be provided on individual substrates (not illustrated), respectively.

Furthermore, in each of the organic EL elements 10a, 11a, 10b, and 10c in Figs. 1 to 4, a hole injection layer (not illustrated) may be provided between the first electrodes 3a, 3b, and 3c, and the hole transport layers 42a, 42b, and 42c, or alternatively, an electron injection layer (not illustrated) may be provided between the electron transport layers 43a, 43b, and 43c, and the second electrodes 5a, 5b, and 5c, as necessary.

When the hole injection layer is provided, a mixed layer (not illustrated) in which the forming materials of both of the hole transport layer and the hole injection layer are mixed in may be provided between each of the hole transport layers 42a, 42b, and 42c, and the hole injection layer. When the electron injection layer is provided, a mixed layer (not illustrated) in which the forming materials of both of the electron transport layer and the electron injection layer are mixed in may be provided between each of the electron transport layers 43a, 43b, and 43c, and the electron injection layer.

Figs. 1 to 4 illustrate configuration examples of the organic EL elements when the first electrodes 3a, 3b, and 3c are positive electrodes and the second electrodes 5a, 5b, and 5c are negative electrodes, respectively.

When the first electrodes 3a, 3b, and 3c are negative electrodes and the second electrodes 5a, 5b, and 5c are positive electrodes, respectively, the sequences of each layer configuring the organic EL layers 4a, 4b, and 4c are changed accordingly.

It should be noted that thickness ratios of each layer illustrated in Figs. 1 to 4 are different from real thickness ratios.

In the present specification, the wording "AAA to BBB" means that "AAA or more and BBB or less".

### (Substrate)

The substrate described above is not particularly limited, and examples thereof include a glass plate, a ceramic plate, a film made of synthetic resin, and a metal plate such as stainless, copper, titanium, aluminum, and the like. When allowing light from the light emitting layer to exit to outside through the substrate, a substrate permeable to light is used. Examples of the substrate permeable to light include a glass plate, a transparent film made of synthetic resin, and the like. Furthermore, an insulating layer may be provided on the substrate.

On the surface of the substrate, various wirings, driver circuits and/or switching elements for driving the organic EL element may be provided.

### (Electrode)

The above mentioned first electrode and the second electrode each made of a film having electrical conductivity

Each forming material of the first electrode and the second electrode is not particularly limited.

When one of the electrodes is used as a positive electrode, examples of the forming material thereof include indium tin oxide (ITO); silicon oxide-containing indium tin oxide (ITSO); gold; platinum; nickel; tungsten; copper; silver; aluminum; and the like.

When one of the other electrodes is used as a positive electrode, examples of the material for forming the electrode include aluminum; alkali metal such as lithium and cesium; alkali earth metal such as magnesium and calcium; rare earth metal such as ytterbium; an alloy such as an aluminum-lithium alloy and a magnesium-silver alloy; and the like.

One or both of the first electrode and the second electrode should be permeable to light for allowing light from the light emitting layer to exit to outside. Therefore, at least one of the first electrode and the second electrode is formed with, for example, a conductive film made of a forming material permeable to light, a very thin conductive film so as to have the transparency of light (for example, a thickness of several nm to several tens of nm), or the like. Examples of the forming material for the electrode permeable to light include a metallic oxide such as ITO and zinc oxide.

The method for forming the first electrode and the second electrode is not particularly limited, and examples thereof include a vapor deposition method, a sputtering method, an inkjet method, and the like.

### (Hole transport layer and hole injection layer)

The hole transport layer described above is a layer having a function of transporting holes injected from the positive electrode (the electrode) to the light emitting layer. The hole injection layer described above is a layer having a function of assisting the injection of the holes from the positive electrode to the hole transport layer. The hole transport layer and the hole injection layer are not always necessary. It is preferable, however, that at least the hole transport layer is provided in the organic EL element, and it is more preferable that both of the hole transport layer and the hole injection layer are provided in the organic EL element.

By providing the hole transport layer, holes are easy to be injected to the light emitting layer, and further, optical quenching of light from the light emitting layer by metal in the electrode can be prevented.

The material for forming the hole transport layer is not particularly limited as long as it is a material having a hole transport function. Examples of the material for forming the hole transport layer include aromatic amine compounds such as 4,4'-bis[N-(1-naphthyl)-N-phenylamino]biphenyl(NPB) and 4,4'-bis[N-(3-methylphenyl)-N-phenylamino]biphenyl (TPD); carbazole derivatives such as 1,3-bis(N-carbazolyl)benzene; and the like. The material for forming the hole transport layer may be used alone or in combination of two or more materials.

The material for forming a hole injection layer is not particularly limited, and examples thereof include metallic oxides such as a vanadium oxide, a niobium oxide, and a tantalum oxide; phthalocyanine compounds such as phthalocyanine; polymer compounds such as a mixture of 3, 4-ethylenedioxythiophene and polystyrene sulfonic acid (PEDOT/PSS); the above mentioned materials for forming the hole transport layer; and the like. The material for forming the hole injection layer may be used alone or in combination of two or more materials.

In the present invention, the hole transport layer and the hole injection layer configuring the organic EL layer are formed by a vapor deposition method.

### (Light emitting layer)

The material for forming the light emitting layer is not particularly limited as long as it is a material having a light emitting property. As the material for forming the light emitting layer, a low-molecular-weight fluorescent material or a low-molecular-weight phosphorescent material may be used, for example.

Examples of the low-molecular-weight light emitting material include aromatic dimethylidene compounds such as 4,4'-bis(2,2'-diphenylvinyl)-biphenyl (DPVBi); oxadiazole compounds such as 5-methyl-2-[2-[4-(5-methyl-2-benzoxazolyl)phenyl]vinyl]benzoxazolel triazole derivatives such as 3-(4-biphenylyl)-4-phenyl-5-t-butylphenyl-1,2,4-triazole (TAZ); styrylbenzene compounds such as 1,4-bis(2-methylstyryl)benzene; benzoquinone derivatives; naphthoquinone derivatives; anthraquinone derivatives; fluorenone derivatives; and organic metal complexes such as an azomethine-zinc complex and tris(8-quinolinolato) aluminum (Alq₃); and the like.

As the material for forming the light emitting layer, a material doped with a luminous dopant material in a host material may be used.

As the host material, for example, the above described low-molecular-weight light emitting material may be used, or alternatively carbazole derivatives such as 1,3-bis(N-carbazolyl)benzene (mCP), 4,4'-bis(9-carbazolyl)-2,2'- biphenyl (CBP), 2,6-bis(N-carbazolyl)pyridine, 9,9-di(4-dicarbazole-benzyl)fluorene (CPF), and the like may be used.

As the dopant material, for example, styryl derivatives; perylene derivatives; a phosphorescent metal complexes such as organic iridium complexes such as tris(2-phenylpyridyl)iridium (III) (Ir(ppy)₃), and tris(1-phenylisoquinoline)iridium (III) (Ir(piq)₃) may be used.

Moreover, the material for forming the light emitting layer may contain the above described material for forming the hole transport layer as described above, the material for forming the electron transport layer described below, and various kinds of additives.

In the present invention, the light emitting layer configuring the organic EL layer is formed by a vapor deposition method.

### (Electron transport layer and electron injection layer)

The electron transport layer described above is a layer having a function of transporting electrons injected from the negative electrode (the electrode) to the light emitting layer. The hole injection layer described above is a layer having a function of assisting the injection of the electrons from the negative electrode to the electron transport layer. The electron transport layer and the electron injection layer are not always necessary. It is preferable, however, that at least the electron transport layer is provided in the organic EL element, and it is more preferable that both of the electron transport layer and the electron injection layer are provided in the organic EL element.

By providing the electron transport layer, electrons are easy to be injected to light emitting layer, and further, optical quenching of light from the light emitting layer by metal in the electrode can be prevented.

The material for forming the electron transport layer is not particularly limited as long as it is a material having an electron transport function. Examples of the material for forming the electron transport material include organic metal complexes such as tris(8-quinolinolato) aluminum Wq₃) and bis(2-methyl-8-quinolinolato)(4-phenylphenolato)aluminum (BAlq); heteroaromatic compounds such as 2-(4-biphenylyl)-5-(4-tert-butylphenyl)-1,3,4-oxadiazale (PBD) and 1,3-bis[5-(p-tert-butylphenyl)-1,3,4-oxadiazole-2-yl]benzene (OXD-7); and the like. The material for forming the electron transport layer may be used alone or in combination of two or more materials.

The material for forming the electron injection layer is not particularly limited, and examples thereof include alkali metal compounds such as lithium fluoride (LiF) and cesium fluoride (CsF); alkaline earth metal compounds such as calcium fluoride (CaF₂); the material for forming the electron transport layer; and the like. The material for forming the electron injection layer may be used alone or in combination of two or more materials.

In the present invention, the electron injection layer and the electron transport layer configuring the organic EL layer are formed by a vapor deposition method.

When voltage is applied to the electrode of the organic EL element, electrons injected from the negative electrode and holes injected from the positive electrode are recombined in the light emitting layer. Light is emitted when the organic compound in the light emitting layer is returned from an excited state to a ground state.

The organic EL layer has the hole transport mixed layer or/and the electron transport mixed layer, and thus, a mobility barrier of holes and electrons between the hole transport layer and the light emitting layer or/and between the electron transport layer and the light emitting layer is reduced. The holes or/and the electrons are therefore smoothly injected into the light emitting layer. The organic EL element of the present invention having the organic EL layer as described above has excellent light emitting efficacy.

### [Production method of organic EL element]

A production method of the organic EL element of the present invention has a characteristic in forming the organic EL layer. The organic EL layer has at least two organic layers of a first organic layer and a second organic layer and a mixed layer in which forming materials of both of the layers are mixed between the first organic layer and the second organic layer. The organic EL layer as described above is provided between the two electrodes.

In other words, in the production method of the present invention at the time of forming the organic EL layer, a vapor deposition apparatus including a first vapor deposition source including the first organic layer forming material (hereinafter sometimes referred to as a "first forming material") and a second vapor deposition source including the second organic layer forming material (hereinafter sometimes referred to as a "second forming material") is used, and the first organic layer is formed on a surface to be processed of a substrate by colliding the first forming material vaporized from the first vapor deposition source with the surface to be processed of the substrate; and thereafter, the mixed layer and the second organic layer are simultaneously formed by colliding the second forming material vaporized from the second vapor deposition source with the first organic layer in a migration state of the first forming material.

In the present invention, the first forming material being in the migration state means that the first forming material formed as the first organic layer (a vapor-deposited film) is not fully solidified and the molecules of the first forming material can be moved by colliding molecules of the first forming material with molecules of the vaporized second forming material.

Meaning of the vaporization includes the case that a material is changed from a solid phase through a liquid phase to a gas phase to form a gas and the case that a material is changed from a solid phase to a gas phase (sublimation) to form a gas.

In the production method of the present invention, the second forming material is permeated into the first forming material (the first organic layer being a vapor-deposited film) by colliding the vaporized second forming material when the first forming material, which is deposited as the vapor-deposited film, is in the migration state. Consequently, a region where the first forming material and the second forming material are mixed (a mixed layer) is generated on the surface of the first organic layer (the vapor-deposited film), and the second organic layer (a vapor-deposited film made of the second forming material) is generated on the region. Usually, in a thickness direction, the region has graduation that weight percent of the first forming material is increased as a position is close to the first organic layer and weight percent of the second forming material is increased as a position is close to the second organic layer. The organic EL layer having substantially no interface, therefore, can be formed between the first organic layer and the second organic layer.

Hereinafter, the production method of the organic EL element of the present invention is specifically described, separately describing each process.

The production of the organic EL element of the present invention can be largely separated to a process of forming a first electrode on a substrate, a process of forming an organic EL layer on the first electrode, and a process of forming a second electrode on the organic EL layer in chronological order.

### (Process for forming first electrode)

This process is a process for forming the first electrode on one side of the surface of the substrate.

The substrate can be used by adequately selecting from the examples described above. Particularly, it is preferably that the substrate being lengthy and sheet-like and having flexibility is used because the organic EL element can be produced by the roll-to-roll method. The "lengthy" form means a long plate-like form having sufficiently long length in a longitudinal direction (a direction which is orthogonal to a width direction) to the length in the width direction, and, for example, the length in the longitudinal direction is 10 times or more longer and preferably 30 times or more longer than the length of the width direction.

The forming material of an electrode such as indium tin oxide is stacked on the one side of the surface of the substrate, and thereby, the first electrode can be formed on the substrate.

The first electrode can be formed by conventionally known methods. Examples of the method for producing the first electrode include a sputter method, a vapor deposition method, and an ink-jet method.

Here, when the substrate has the function of the first electrode, this process not always has to be carried out and the substrate itself may be used as the first electrode.

### (Process for forming organic EL layer)

This process is a process for forming an organic EL layer having at least two organic layers of the first organic layer and the second organic layer, and a mixed layer in which the forming materials of both of the layers are mixed between the first organic layer and the second organic layer.

When three or more of the organic layers are provided, as long as the mixed layer is provided between two adjacent organic layers selected from these three or more of the layers, the mixed layer is provided between other organic layers or the mixed layer is not provided between other organic layers.

Each organic layer configuring the organic EL layer is formed by a vapor deposition method.

In the vapor deposition, a vapor deposition apparatus that includes a first vapor deposition source including the first organic layer forming material and a second vapor deposition source including the second organic layer forming material is used.

As described above, when three or more of the organic layers are provided, a vapor deposition apparatus that further includes a third vapor deposition source including the forming material of the third organic layer (hereinafter, sometimes referred to as a "third forming material") is used. That is, the vapor deposition apparatus has at least two vapor deposition sources of the first vapor deposition source and the second vapor deposition source. Preferably, these vapor deposition sources are arranged in one chamber.

Fig. 5 illustrates a conceptual diagram of a vapor deposition apparatus for forming an organic EL layer.

In Fig. 5, the vapor deposition apparatus 7 has a chamber 71 whose inside is vacuum, the first vapor deposition source 721 and the second vapor deposition source 722 which are arranged in the chamber 71. The first vapor deposition source 721 and the second vapor deposition source 722 include discharge openings 721e and 722e that are outlets of the vaporized first forming material and second forming material.

The first vapor deposition source 721 and the second vapor deposition source 722 are parallelly arranged in one chamber 71. The cost of the facilities can be reduced by arranging these vapor deposition sources 721 and 722 in one chamber 71.

In the first vapor deposition source 721 and the second vapor deposition source 722, each of the discharge openings 721e and 722e is arranged facing to a surface to be processed of the substrate 73 so that each vaporized forming material is collided in an almost orthogonal direction with the surface to be processed of the substrate 73.

In the vapor deposition apparatus 7 of the present invention, it is important that a distance D2 between the discharge opening 722e of the second vapor deposition source 722 and the surface to be processed of the substrate 73 is set to 0.1 mm to 5.0 mm. Although a distance D1 between the discharge opening 721e of the first vapor deposition source 721 and the surface to be processed of the substrate 73 is not particularly limited, this distance D1 is also preferably set to 0.1 mm to 5.0 mm.

Here, the distances D1 and D2 are lengths of straight lines between the surface to be processed and the discharge opening in an almost orthogonal direction to the surface to be processed of the substrate.

The vapor deposition apparatus 7 also includes a carrier device for relatively moving each of the vapor deposition sources 721 and 722 and the substrate 73 in the chamber 71. A rate of the relative movement is preferably a constant rate during vapor deposition.

The carrier device only moves each vapor deposition source, keeping a distance between the discharge opening of each vapor deposition source and the substrate, or only moves the substrate, similarly keeping the distance, or moves each vapor deposition source and the substrate in an opposite direction each other, similarly keeping the distance.

The carrier device is preferably configured so that each vapor deposition source is fixed at predetermined positions in the chamber and only the substrate is moved, keeping the distance between the discharge opening and the substrate, because the apparatus can be easily configured. Rollers 74 that deliver a sheet-like substrate 73 in one direction and wind the substrate 73 are used as the carrier device because the substrate 73 in the illustrated example is used in the roll-to-roll method.

The first vapor deposition source 721 is arranged in an upstream side in the carrying direction of the substrate 73 and the second vapor deposition source 722 is arranged in a downstream side of the first vapor deposition source 721.

A deposition prevention wall 75 is provided between the parallelly arranged first vapor deposition source 721 and second vapor deposition source 722. By the deposition prevention wall 75, permeation of the vaporized first forming material into the second vapor deposition source 722 and/or permeation of the vaporized second forming material into the first vapor deposition source 721 can be prevented (in other words, contamination of each vapor deposition source can be prevented).

When the organic EL layer is formed using the vapor deposition apparatus 7, first, the substrate 73 having the first electrode is introduced in the chamber 71 in a vacuum state by the carrier device 74. The vacuum means a state in which a degree of vacuum is 10⁻¹ Pa or less.

The first vapor deposition source 721 is heated to vaporize the first forming material and the vaporized first forming material is released from the discharge opening 721e. The first forming material released from the discharge opening 721e to the chamber 71 is collided with the surface to be processed of the substrate 73 (the surface of the first electrode) and deposited. Consequently, the first organic layer being a vapor-deposited film made of the first forming material is formed on the surface to be processed of the substrate 73.

Next, the second vapor deposition source 722 is heated to vaporize the second forming material and the vaporized second forming material is released from the discharge opening 722e. The second forming material released from the discharge opening 722e to the chamber 71 is collided with the surface of the first organic layer being a vapor-deposited film made of the first forming material and deposited.

The vaporized second forming material is collided with the first forming material being a vapor-deposited film in the migration state. A mixed layer being a region where the first forming material and the second forming material are mixed can be formed by colliding the vaporized second forming material when the first forming material is in the migration state.

Each vapor deposition rate of the first forming material and the second forming material is not particularly limited, but the vapor deposition rate of the second forming material is preferably 40 nm/second to 500nm/ second, and further, both vapor deposition rates of the first forming material and the second forming material are more preferably 40 nm/ second to 500 nm/ second.

A heating temperature of the first vapor deposition source 721 and the second vapor deposition source 722 is a temperature that is sufficient for vaporizing the first forming material and the second forming material.

As described above, the organic EL layer integrating the vapor-deposited film of the first forming material (the first organic layer), the region where the first forming material and the second forming material are mixed (the mixed layer), and the vapor-deposited film of the second forming material (the second organic layer) can be formed.

The organic EL element including the obtained organic EL layer has excellent electric properties.

The inventors of the present invention assume the reason why the organic EL element having excellent electric properties is obtained by the production method of the present invention as described below.

Just after a vapor-deposited film has been formed by the vapor deposition of the first forming material, the vapor-deposited film is not stable and the first forming material is in a state in which the first forming material can be moved. When the first forming material is in this state in which the first forming material can be moved, the second forming material permeates into the first forming material configuring the vapor-deposited film by colliding the second forming material. Consequently, a region where the first forming material and the second forming material are gradually mixed is generated on the surface of the vapor-deposited film. The obtained organic EL element has, therefore, excellent electric properties because the mixed layer having excellent gradation of both forming materials exists between the two organic layers.

When a distance between the discharge opening of the second vapor deposition source and the surface to be processed of the substrate is set to 0.1 mm to 5.0 mm, the mixed layer having particularly excellent gradation can be formed.

When the distance is less than 0.1 mm, the second forming material vaporized from the second vapor deposition source collides with the first organic layer too hard. Consequently, the second forming material permeates too deep into the first organic layer in a thickness direction, or the vaporized second forming material flicks the first forming material away from the substrate. Therefore, when the distance is less than 0.1 mm, the organic EL layer having the excellent mixed layer may not be formed.

When the distance exceeds 5.0 mm, vapor deposition of the second forming material in a predetermined vapor deposition rate becomes difficult (it takes much time to form the second organic layer being the vapor-deposited film made of the second forming material in a predetermined thickness), and a permeation amount of the second forming material to the first organic layer becomes less. When the distance exceeds 5.0 mm, therefore, the organic EL layer having the excellent mixed layer may not be formed.

When a distance between the discharge opening of the first vapor deposition source and the surface to be processed of the substrate is set to 0.1 mm to 5.0 mm, a first organic layer having a predetermined thickness can be formed.

When the distance is less than 0.1 mm, the first forming material vaporized from the first vapor deposition source collides with the surface to be processed of the substrate too hard. Consequently, the vaporized first forming material flicks on the surface to be processed, and thus, the first organic layer having the predetermined thickness is difficult to form.

When the distance exceeds 5.0 mm, vapor deposition of the first forming material in a predetermined vapor deposition rate becomes difficult. In other words, it takes much time to form the first organic layer being the vapor-deposited film made of the first forming material in a predetermined thickness.

According to verification of the inventors, it is preferable that after a first organic layer is formed, a vaporized second forming material is collided with the first organic layer during a period of 0.3 seconds to 3.0 seconds.

During a period of less than 0.3 seconds after the first organic layer is formed, a degree of freedom of motion of the first forming material in the first organic layer is too large. Consequently, when the second forming material is collided with the first organic layer during the period of less than 0.3 seconds, the permeation of the second forming material into the first organic layer in a thickness direction becomes too deep, or the vaporized second forming material flicks the first forming material away from the substrate. The organic EL layer having the excellent mixed layer, therefore, may not be formed.

When a period exceeds 3.0 seconds after the first organic layer is formed, a degree of freedom of motion of the first forming material in the first organic layer becomes small. Consequently, when the second forming material collides with the first organic layer after the period exceeding 3.0 seconds, a permeation amount of the second forming material to the first organic layer may become less. The organic EL layer having the excellent mixed layer, therefore, may not be formed.

Furthermore, as described above, the vapor deposition rate of the second forming material is preferably 40 nm/second to 500 nm/second.

When the vapor deposition rate of the second forming material is less than 40 nm/second, the vaporized second forming material does not have such collision energy that it is permeated into the first organic layer. Consequently, the organic EL layer having the excellent mixed layer may not be formed.

When the vapor deposition rate of the second forming material exceeds 500 nm/second, the collision energy of the vaporized second forming material is too strong, and therefore, the organic EL layer having the excellent mixed layer may not be formed.

Fig. 6 illustrates a reference view of a configuration example of a vapor deposition apparatus for forming the A type organic EL layer.

In Fig. 6, a vapor deposition apparatus 8 has a chamber 81 whose inside is vacuum, each of vapor deposition sources 821, 822, and 823 arranged in the chamber 81, and a carrier device 84 which carries a substrate 83 into the chamber 81.

In Fig. 6, the first vapor deposition source 821 that vaporizes a first forming material 861, the second vapor deposition source 822 that vaporizes a second forming material 862, and the third vapor deposition source 823 that vaporizes a third forming material 863 are provided as vapor deposition sources.

The first vapor deposition source 821, the second vapor deposition source 822, and the third vapor deposition source 823 are sequentially arranged in a carrying direction of the substrate 83 and are fixed in one chamber 81.

A distance between the first vapor deposition source 821 and the second vapor deposition source 822 and a distance between the second vapor deposition source 822 and the third vapor deposition source 823 are adequately determined in consideration of a vapor deposition rate, a carrying rate of the substrate 83, and the like. Specifically, during a period of 0.3 seconds to 3.0 seconds after one vapor-deposited film is formed, a next forming material preferably collides with the vapor-deposited film as described above. In the roll-to-roll method in which vapor deposition is continuously carried out, the next forming material can collide during the period of 0.3 seconds to 3.0 seconds by adequately adjusting arranged distances of each of the vapor deposition sources 821, 822, and 823 and/or the carrying rate of the substrate 83.

The distance between the first vapor deposition source 821 and the second vapor deposition source 822 and the distance between the second vapor deposition source 822 and the third vapor deposition source 823 are corresponding to lengths of straight lines between centers of discharge openings of each vapor deposition source in the carrying direction of the substrate.

The first vapor deposition source 821, the second vapor deposition source 822, and the third vapor deposition source 823 have heat resistant containers 821f, 822f, and 823f, discharge openings 821e, 822e, and 823e, and heat sources (not illustrated) to heat up the heat resistant containers 821f, 822f, and 823f, respectively. The heat resistant containers 821f, 822f, and 823f stores each of the first forming material 861, the second forming material 862, and the third forming material 863. The discharge openings 821e, 822e, and 823e are provided at the end portions of the heat resistant containers 821f, 822f, and 823f, and are outlets of each vaporized forming material.

As each of the heat resistant containers 821f, 822f, and 823f, containers having gas tight properties of not leaking each vaporized forming material and heat resistance of not melting the containers by heat from heat sources are used.

Opening shapes of each of the discharge openings 821e, 822e, and 823e are not particularly limited, and examples thereof include a circle shape, an elliptical shape, quadrangular shapes such as a rectangular shape and a square shape, and other polygonal shapes.

Opening areas of each of the discharge openings 821e, 822e, and 823e are not particularly limited, and are determined depending on a width of the substrate, a vapor deposition rate, a carrying rate, and the like. Opening widths of each discharge opening are preferably smaller than the width of the vapor-deposited film. Opening lengths of each discharge opening in a longitudinal direction (a carrying direction) are preferably 0.5 mm to 100 mm. When the opening areas of each discharge opening are smaller than the opening areas as described above, each forming material may be clogged. When the opening areas of each discharge opening are larger than the opening areas, a size of the apparatus itself may be large. In each discharge opening, a film thickness correction means for correcting a film thickness distribution may be provided.

When three or more of the organic layers are provided, a third vapor deposition source 823 including the forming material of the third organic layer (hereinafter, sometimes referred to as a "third forming material") is arranged in the vapor deposition apparatus.

As described above, the first vapor deposition source 821, the second vapor deposition source 822, and the third vapor deposition source 823 are arranged so that each distance between each of the discharge openings 821e, 822e, and 823e and the substrate 83 is 0.1 mm to 5.0 mm.

As described above, the distances between each of the vapor deposition sources 821, 822, and 823 and the substrate 83 are 0.1 mm to 5.0 mm, which are short distances, and thus, the chamber 81 having relatively small capacity can be used. Consequently, the vapor deposition apparatus of the present invention is also small.

A method for heating each of the vapor deposition sources 821, 822, and 823 (heat sources) is not particularly limited, and heat resistant containers may be heated by directly conducting electricity to the heat resistant containers or the heat resistant containers may be heated by using heaters (infrared lamps or the like) separately provided.

Each of the deposition prevention walls 85 are provided between the first vapor deposition source 821 and the second vapor deposition source 822 and between the second vapor deposition source 822 and the third vapor deposition source 823. Apices of the deposition prevention walls 85 are protruded higher than the discharge openings 821e, 822e, and 823e of each of the vapor deposition sources 821, 822, and 823, but do not contact to the substrate 83.

In the vapor deposition apparatus illustrated in Fig. 6, for example, a forming material for the hole transport layer as the first forming material 861 is filled in the first vapor deposition source 821, a forming material for the light emitting layer as the second forming material 862 is filled in the second vapor deposition source 822, and a forming material for the electron transport layer as the third forming material 863 is filled in the third vapor deposition source 823.

Then, a vapor-deposited film (the first organic layer) made of the first forming material is formed on the substrate 83 by carrying the substrate 83 in the carrying direction, heating the first vapor deposition source 821, and vaporizing the first forming material (the material for the hole transport layer). When the substrate 83 is further carried, the second forming material (a forming material for the light emitting layer) vaporized from the second vapor deposition source 822 arranged in a downstream side in the carrying direction collides with the first organic layer during the first forming material being in the migration state, and thus, a mixed layer in which the first forming material and the second forming material are mixed and a vapor-deposited film (the second organic layer) made of the second forming material are formed. When the substrate 83 is further carried, the third forming material (a forming material for the electron transport layer) vaporized from the third vapor deposition source 823 arranged in a downstream side in the carrying direction collides with the second organic layer during the second forming material being in the migration state, and thus, a mixed layer in which the second forming material and the third forming material are mixed and a vapor-deposited film (the third organic layer) made of the third forming material are formed.

As described above, an organic EL layer 4 as illustrated in Fig. 1 on which the hole transport layer 41a, the hole transport mixed layer 412a, the light emitting layer 42a, the electron transport mixed layer 423a, and the electron transport layer 43a are stacked on a first electrode 3a in this order can be formed.

The organic EL layer as illustrated in Fig. 2that does not include the electron transport mixed layer between the light emitting layer 42a and the electron transport layer 43a can be formed by, for example, a method for arranging the third vapor deposition source 823 further away from the second vapor deposition source 822 in a downstream side when the vapor deposition apparatus is designed and a method for arranging the third vapor deposition source 823 so that a distance between the third vapor deposition source 823 and the substrate 83 exceeds 5.0 mm.

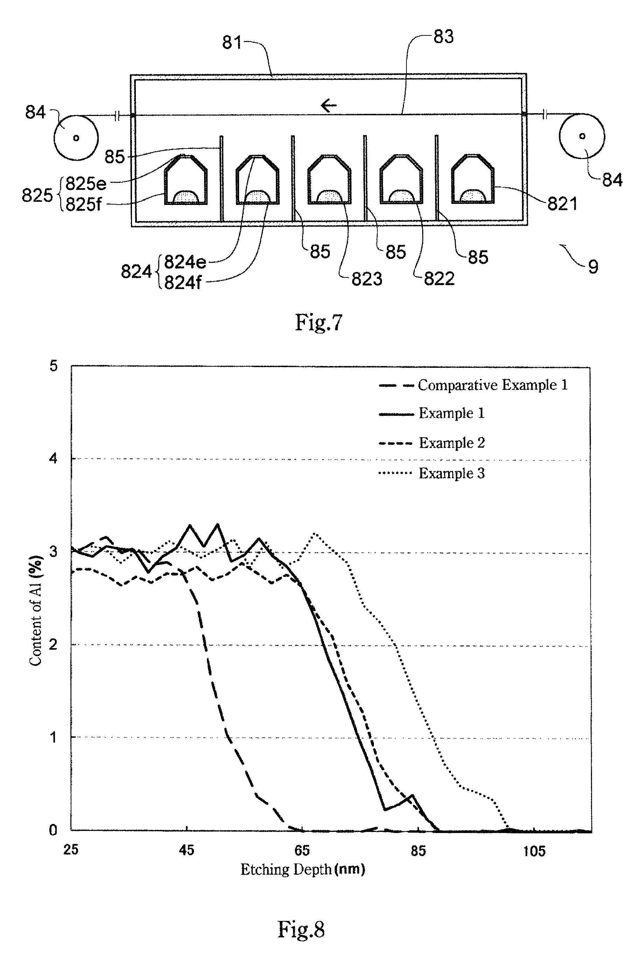

Fig. 7 illustrates a reference view of a configuration example of a vapor deposition apparatus for forming the A type organic EL layer in which a hole injection layer and an electron injection layer are provided.

The vapor deposition apparatus 9 in Fig. 7 is the same as the vapor deposition apparatus 8 in Fig. 6 except that a fourth vapor deposition source 824 and a fifth vapor deposition source 825 are further provided. Consequently, in the description of the vapor deposition apparatus in Fig. 7, description which a similar configuration to the vapor deposition apparatus in Fig. 6 is omitted, and the terms and the reference numerals are used without any change.

In the chamber 81 of the vapor deposition apparatus 9 in Fig. 7, the first to fifth vapor deposition sources 821, 822, 823, 824, and 825, which have similar configuration to the above description, are sequentially arranged. The fourth vapor deposition source 824 and the fifth vapor deposition source 825 are parallelly arranged in a downstream side of the third vapor deposition source 823. Distances between each of the discharge openings 824e and 825e of the fourth and fifth vapor deposition sources 824 and 825 and the substrate 83 may be set to 0.1 mm to 5.0 mm or may be out of the range of 0.1 mm to 5.0 mm.

At least one distance between the first to fifth vapor deposition sources 821, 822, 823, 824, and 825 and the substrate 83 may be 0.1 mm to 5.0 mm.

In the vapor deposition apparatus 9 in Fig. 7, vapor deposition is carried out by filling the forming material of the hole injection layer to the first vapor deposition source 821, filling the forming material of the hole transport layer to the second vapor deposition source 822, filling the forming material of the light emitting layer to the third vapor deposition source 823, filling the forming material of the electron transport layer to the fourth vapor deposition source 824, and filling the forming material of the electron injection layer to the fifth vapor deposition source 825.

In this case, mixed layers in which each forming material are mixed can be formed between each layer of the hole injection layer, the hole transport layer, the light emitting layer, the electron transport layer, and the electron injection layer by colliding the next forming material to the vapor-deposited films sequentially formed with each forming material in a migration state.

As described above, whether the mixed layer is formed or not can be adequately selected by adequately changing the design of the vapor deposition apparatus.

The forming material for filling the first to fifth vapor deposition sources 821, 822, 823, 824, and 825 of the vapor deposition apparatus 9 in Fig. 7 can be suitably selected. For example, when the forming material of the light emitting layer has an electron transport function, vapor deposition may be carried out by filling the forming material of the hole injection layer to the first vapor deposition source 821, filling the forming material of the hole transport layer to the second vapor deposition source 822, filling the forming material of the light emitting layer to the third vapor deposition source 823, filling the forming material of the electron injection layer to the fourth vapor deposition source 824, and filling the forming material of the second electrode to the fifth vapor deposition source 825. In this case, a process of forming the second electrode described below and the process of forming the organic EL layer can be simultaneously carried out in one chamber.

The B type organic EL layer can be formed by using the vapor deposition apparatus in Fig. 6 or Fig. 7, or can be formed by using a deposition apparatus, although not particularly illustrated, in which two vapor deposition source of the first vapor deposition source and the second vapor deposition source are arranged in a chamber.

### (Process of forming second electrode)

This process is a process of forming a second electrode on one side of an organic EL layer.

The second electrode can be formed by conventionally known methods. Examples of the method for producing the second electrode include a sputtering method, a vapor deposition method, and an ink-jet method.

The organic EL element of the present invention is obtained by the above processes.

The production method for the organic EL element of the present invention, however, may have other processes other than each of the processes described above.

### EXAMPLES

Hereinafter, the present invention is described in detail with reference to following Examples and Comparative Examples. However, the present invention is not limited to the following Examples.

### [Example 1]

A substrate (thickness 0.1 mm) made of glass on which indium tin oxide (ITO) having a thickness of 100 nm was patterned was prepared as a positive electrode.

As the vapor deposition apparatus, a roll-to-roll vacuum vapor deposition apparatus was used. In this vacuum vapor deposition apparatus, first to fifth vapor deposition sources were sequentially arranged in a chamber as illustrated in Fig. 7, and CuPc, NPB, Alq₃, LiF, and Al were filled. in the first to fifth vapor deposition sources in this order. In the vacuum vapor deposition apparatus, both distances between the first vapor deposition source in which CuPc was filled and the second vapor deposition source in whcih NPB was filled and between the second vapor deposition source and the third vapor deposition source in which Alq₃ was filled were set to 100 mm. Also, in the vacuum vapor deposition apparatus, both distances between discharge openings of the second vapor deposition source in which NPB was filled and the third vapor deposition source in which Alq₃ was filled and a substrate were set to 1.0 mm.

The substrate was introduced into the chamber in a predetermined carrying rate, and vapor deposition of a copper phthalocyanine film (a CuPc film) having a thickness of 25 nm as the hole injection layer, a 4,4'-bis[N-(1-naphthyl)-N-phenylaminol biphenyl film (an NPB film) having a thickness of 60 nm as the hole transport layer, a tris(8-hydroxyquinolinato)aluminum film (an Alq₃ film) having a thickness of 60 nm as the light emitting layer also acting as the electron transport layer, a lithium fluoride film (an LiF film) having a thickness of 0.5 nm as the electron injection layer, and an aluminum film (an Al film) having a thickness of 100 nm as the negative electrode was carried out on the surface of the ITO layer of the substrate in this order, with each vapor deposition source being heated at a predetermined temperature.

A carrying rate of the substrate was designed so that the vaporized Alq₃ was collided with the surface of the NPB film after 2.3 seconds after the NPB film was formed. Specifically, the carrying rate of the substrate was set to 1.8 m/minute.

In Table 1, distances between the discharge opening of the second vapor deposition source and the substrate, distances between the discharge opening of the third vapor deposition source and the substrate, each of vapor deposition rates of NPB and Alq₃, and time from after forming an NPB film to collision of vaporized Alq₃ with the surface of the film are shown, respectively.

### [Examples 2 to 5 and Comparative Examples 1 to 3]

A vapor deposition is carried out in the same manner as in Example 1 except that the distance between the discharge opening of the second vapor deposition source and the substrate, the distance between the discharge opening of the third vapor deposition source and the substrate, each of vapor deposition rates of NPB and Alq₃, and time from after forming an NPB film to collision of vaporized Alq₃ with the surface of the film are changed as shown in Table 1, respectively.

**[Table 1]**

| | Example 1 | Example 2 | Example 3 | Example 4 | Example 5 | Comparative Example 1 | Comparative Example 2 | Comparative Example 3 |
|---|---|---|---|---|---|---|---|---|
| Distances between second vapor deposition source and Substrate (mm) | 4.0 | 2.1 | 1.7 | 1.5 | 1.1 | 100 | 30 | 10 |
| Distances between third vapor deposition source and substrate (mm) | 4.0 | 2.1 | 1.7 | 1.5 | 1.1 | 100 | 30 | 10 |
| Vapor deposition rate of NPB (mm/s) | 50 | 200 | 300 | 400 | 800 | 0.1 | 1 | 10 |
| Vapor deposition rate of Alq3 (mm/s) | 50 | 200 | 300 | 400 | 800 | 0.1 | 1 | 10 |
| Time to collision of Alq₃(s) | 2.3 | 1.2 | 0.6 | 0.4 | 0.2 | 1200 | 120 | 12 |
| Region which composition change is observed (nm) | 26 | 25 | 27 | 30 | 48 | 20 | 20 | 21 |
| Current efficiency (cd/A) | 4.0 | 4.1 | 4.3 | 4.2 | 4.0 | 3.5 | 3.4 | 3.6 |

### [Measurement of mixed layer]

Whether a mixed layer in which the NPB film and Alq₃ were mixed exists or not between the NPB film and the Alq₃ film was determined for each organic EL element prepared in Examples 1 to 5 and Comparative Examples of 1 to 3.

As a measurement method, a depth profile was measured by analyzing a composition using ESCA (Electron Spectroscopy for Chemical Analysis), that is, X-ray Photoelectron Spectroscopy, carrying out etching with Ar ions from a surface side of the Alq₃ film. Aluminum configuring the Alq₃ film was used as an indicator, a state of the mixed layer was determined by whether aluminum element exists or not. At this time, in Comparative Example 1, a composition change region having a thickness of 20 nm was observed between the NPB film and the Alq₃ film and it was determined that a mixed layer was not formed in this composition change region having a thickness of 20 nm.

The results are shown in Table 1. A graph illustrating a relation of the measurement results between the etching depth and the concentration of Alq₃ is illustrated in Fig. 8.

From Table 1 and Fig. 8, it can be seen that the mixed layer in which the concentration of Alq₃ gradually decreases is formed between the NPB film and the Alq₃ film in each of the organic EL elements in Examples 1 to 5.

In the organic EL elements in Comparative Example 1 to Comparative Example 3, it was determined that a mixed layer was not formed.

### [Measurement of electric properties]

Current efficiency was measured for each of the organic EL elements prepared in Examples 1 to 5 and Comparative Examples 1 to 3.

The current efficiency was measured by using an organic EL luminescence efficiency measurement system (manufactured by PRECISE GAUGES co., ltd., product name: EL1003) at the time of constant current density drive (at the time of a current density of 7.5 mA/cm²).

These results are shown in Table 1.

Table 1 shows that the organic EL elements of Examples 1 to 5 are excellent in the current efficiency as compared to the organic EL element of Comparative Examples 1 to 3.

### [Industrial Applicability]

The organic EL element produced by the production method of the present invention can be used for a display device, an illumination device, and the like.

7...Vapor deposition apparatus, 71...Chamber, 721, 722, 723...First to third vapor deposition sources, 721e, 722e, 723e...Discharge openings of first to third vapor deposition sources, 73...Substrate, 74...Transport apparatus.

## Claims

1. A method for producing an organic electroluminescence element including at least two organic layers of a first organic layer and a second organic layer, and a mixed layer in which forming materials of both of the layers are mixed between the first organic layer and the second organic layer, the method comprising the steps of:
using a vapor deposition apparatus including a first vapor deposition source including the first organic layer forming material and a second vapor deposition source including the second organic layer forming material;
forming the first organic layer on a surface to be processed of a substrate by colliding the first organic layer forming material vaporized from the first vapor deposition source with the surface to be processed of the substrate; and
thereafter, forming the mixed layer by colliding the vaporized second organic layer forming material from the second vapor deposition source with the first organic layer in a migration state of the first organic layer forming material.

2. The method for producing the organic electroluminescence element according to claim 1,
wherein the second vapor deposition source comprises a discharge opening that acts as an outlet of the vaporized second organic layer forming material; and
wherein a distance between the discharge opening of the second vapor deposition source and the surface to be processed of the substrate is set to 0.1 mm to 5.0 mm.

3. The method for producing the organic electroluminescence element according to claim 2,
wherein the first vapor deposition source comprises a discharge opening that acts as an outlet of the vaporized first organic layer forming material; and
wherein a distance between the discharge opening of the first vapor deposition source and the surface to be processed of the substrate is set to 0.1 mm to 5.0 mm.

4. The method for producing the organic electroluminescence element according to any one of claims 1 to 3,
wherein the vaporized second organic layer forming material is collided with the first organic layer during a period of 0.3 seconds to 3.0 seconds after forming the first organic layer.

5. The method for producing the organic electroluminescence element according to any one of claims 1 to 4,
wherein a vapor deposition rate of the second organic layer forming material is 40 nm/second to 500 nm/second.

6. The method for producing the organic electroluminescence element according to any one of claims 1 to 5,
wherein the first organic layer forming material and the second organic layer forming material are sequentially collided, relatively moving the first vapor deposition source and the second vapor deposition source and the substrate.

7. The method for producing the organic electroluminescence element according to any one of claims 1 to 6,
wherein the first vapor deposition source and the second vapor deposition source are parallelly arranged in one chamber of the vapor deposition apparatus; and
wherein the first organic layer forming material and the second organic layer forming material are sequentially collided in the chamber, moving a sheet-like substrate by a roll-to-roll method.
